## Europäisches Patentamt
## European Patent Office
## Office européen des brevets

(19)

(11) Veröffentlichungsnummer: **0 002 798**
**B1**

(12) **EUROPÄISCHE PATENTSCHRIFT**

(45) Veröffentlichungstag der Patentschrift: **15.07.81**

(21) Anmeldenummer: **78101788.4**

(22) Anmeldetag: **20.12.78**

(51) Int. Cl.³: **H 01 L 21/28,**
**H 01 L 21/60,**
**H 01 L 21/306,**
**C 23 C 15/00**

(54) Verfahren zum Entfernen einer Metallschicht von einem Halbleiterkörper durch reaktives Ionenätzen.

(30) Priorität: 30.12.77 US 866087

(43) Veröffentlichungstag der Anmeldung:
11.07.79 Patentblatt 79/14

(45) Bekanntmachung des Hinweises auf die Patenterteilung:
15.07.81 Patentblatt 81/28

(84) Benannte Vertragsstaaten:
DE FR GB

(56) Entgegenhaltungen:
FR - A - 2 312 114
US - A - 3 951 709
CHEMICAL ABSTRACTS, Vol. 85,
Nr. 14, Oktober 1976, Columbus, Ohio, USA,
MIMURA YOSHIAKI: "Etching of titanium with
fluorinc-containing gas plasma", Seite 628
& JP - A - 76 27833 (NIPPON TELEGRAPH AND
TELEPHONE PUBLIC CORP.)
* Zusammenfassung Nr. 85 103059k*
IBM TECHNICAL DISCLOSURE BULLETIN
Vol. 19, Nr. 3, August 1976, New York, USA
H. C. KLUGE et al.: "Etching fine patterns in
chromium and refractory metals", Seite 900
IBM TECHNICAL DISCLOSURE BULLETIN
Vol. 20, Nr. 4, September 1977, New York, USA
T. HANSEN et al.: "Etchant for the reactive ion
etch of metals", Seite 1391

JAPANESE JOURNAL OF APPLIED PHYSICS,
Vol. 16, Nr. 2, 1977, Tokyo, JP
H. KINOSHITA et al.: "Anisotropic etching of
silicon by gas plasma", Seiten 381—382
JOURNAL OF THE ELECTROCHEMICAL SOCIETY,
Vol. 124, Nr. 11, November 1977, Princeton, USA
C. J. MOGAB et al.: "Plasma etching of titanium
for application to the pattering of
Ti-Pd-Au metallization", Seiten 1766—1771

(73) Patentinhaber: International Business Machines
Corporation
Armonk, N.Y. 10504 (US)

(72) Erfinder: Kitcher, James Robert
11 Van Siclen Drive
Poughkeepsie New York 12601 (US)
Erfinder: Ozols, Gunars Miervaldis
26 Academy St. West
Wappingers Falls New York 12590 (US)
Erfinder: Zingerman, Bryant
34 Duelk Avenue
Monroe New York 10950 (US)

(74) Vertreter: Kreidler, Eva-Maria, Dr. rer. nat.
Schönaicher Strasse 220
D-7030 Böblingen (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

Verfahren zum Entfernen einer Metallschicht von einem Halbleiterkörper durch reaktives Ionenätzen

Die Erfindung betrifft ein Verfahren zum Entfernen einer Metallschicht von einem Halbleiterkörper durch reaktives Ionenätzen.

Das Ätzen von Materialien in einem Gasplasma, welches aus reaktiven Gasen erzeugt wurde, ist bekannt. Diese Verfahren können im allgemeinen in zwei Typen unterteilt werden, in das "Plasmaätzen" und das "reaktive Ionenätzen". Beim Plasmaätzen wird das zu ätzende Werkstück in eine Kammer eingebracht, und eine Glimmentladung wird aufrechterhalten, indem Hochfrequenzenergie einer Elektrode oder Elektroden zugeführt wird, die extern zu der Kammer angeordnet sind. Der typische Energiebedarf liegt bei 100 bis 400 Watt bei 13,5 MHz, und die Drucke betragen 0,05 bis einige wenige Torr. Ein Beispiel dieser Vorrichtung und des Verfahrens sind in der US-Patentschrift 3 951 709 beschrieben. Beim reaktiven Ionenätzen wird das Werkstück auf einer Elektrode in einer Kammer angeordnet, und eine Glimmentladung wird aufrechterhalten, indem Hochfrequenzenergie der Elektrode zugeführt wird. Der typische Energiebedarf liegt bei 0,1 bis 0,5 Watt/cm² bei 13,5 MHz, und die Drucke betragen 5 bis 50 Millitorr. Das reaktive Ionenätzen ist ein gerichtetes Ätzverfahren. Ein Beispiel für dieses Verfahren und eine Vorrichtung sind in der US-Patentschrift 3 994 793 beschrieben.

In der US-Patenschrift 3 951 709 ist ein Verfahren zur Herstellung von Halbleiterphotomasken beschrieben, bei dem metallische Schichten wie Chrom oder Gold auf Glas in einem Plasmaätzverfahren unter Anwendung von Gasmischungen chlorhaltiger Verbindungen wie CCl₄ und C₂HCl₃ mit Sauerstoff geätzt werden. In der US-Patentschrift 3 994 793 ist ein Verfahren zum selektiven Ätzen von Aluminium und Aluminiumlegierungen durch reaktives Ionenätzen beschrieben unter Anwendung einer Mischung halogenhaltiger Verbindung wie CCl₄ mit Argon.

Bei der Herstellung von Metallisierungsmustern für integrierte Schaltungen, beispielsweise aus Aluminium, kann es geschehen, daß das Metallisierungsmuster schlecht an den dielektrischen Schichten haftet, und eine Verunreinigung des Halbleiterkörpers durch Legierungsbildung mit dem metallischen Leiter stattfinden kann. Deshalb werden hilfsweise Trennschichten aus Metallen wie Chrom, Titan, Wolfram und Tantal verwendet. Diese metallischen Schichten müssen geätzt werden, ohne daß das Halbleitersubstrat Silicium wie auch die Aluminiummetallisierung wesentlich angegriffen werden. Es ist beispielsweise aus der US-Patentschrift 3 615 956, Spalte 5, Zeilen 24 bis 26 bekannt, daß chlorhaltige Gase sehr schnell Silicium angreifen.

Es wurde nunmehr festgestellt, daß bei Anwendung von Gasmischungen organischer Chlorverbindungen wie CCl₄ oder C₂HCl₃ und Sauerstoff in bestimmten kritischen Proportionen Aluminium oder Silicium nur unwesentlich angegriffen werden, während die metallischen Trennschichten durch reaktives Ionenätzen entfernt werden. Diese Feststellung führt zur Aufgabe der Erfindung, die darin besteht, die Bedingungen für ein Verfahren zum Ätzen von Metallschichten aus Chrom, Titan, Wolfram, Tantal oder aus Legierungen derselben auf dem Halbleiterkörper anzugeben. Die Aufgabe der Erfindung wird durch das Verfahren, das in den Ansprüchen gekennzeichnet ist, gelöst. Es besteht darin, Metallschichten aus Chrom, Titan, Wolfram, Tantal oder aus Legierungen derselben einer Glimmentladung in einer Atmosphäre mit einem Gehalt an polychlorierter organischer Verbindung mit 1 oder 2 C-Atomen von 5 bis 20 Vol.% und an Sauerstoff von 80 bis 95 Vol.% bei einem Gesamtdruck von 5 bis 50 Millitorr auszusetzen.

Vorteilhafte Ausführungsformen der Erfindung sind in den Unteransprüchen beschrieben.

Fig. 1 ist eine graphische Darstellung, aus der die Ätzraten verschiedener Materialien bei verschiedenen Konzentrationen von CCl₄ und O₂ ersichtlich sind.

Fig. 2 ist ein Querschnitt durch eine Halbleiterstruktur nach Anwendung des erfindungsgemäßen Verfahrens.

Das Verfahren zum Ätzen von Chrom-, Titan-, Wolfram- oder Tantal-Schichten und Legierungen derselben wird mittels reaktivem Ionenätzen durchgeführt. Das reaktive Ionenätzen ist ein gerichtetes Ätzverfahren, wodurch steiler geätzte Seitenwände erhalten werden, so daß das darüberliegende Resistmuster in der Metallschicht besser abgebildet wird, als wenn man ein Naßätz- oder Plasmaätzverfahren anwendet. Die letzteren Ätzverfahren sind nichtgerichtete Verfahren, d.h. die Seitenwände unter der Resistmaske werden auch angeätzt. Auch konnten Metallschichten aus Titan-Wolfram-Legierungen unter Verwendung von C₂HCl₃ und Sauerstoffmischungen mit dem Plasmaätzverfahren nicht geätzt werden.

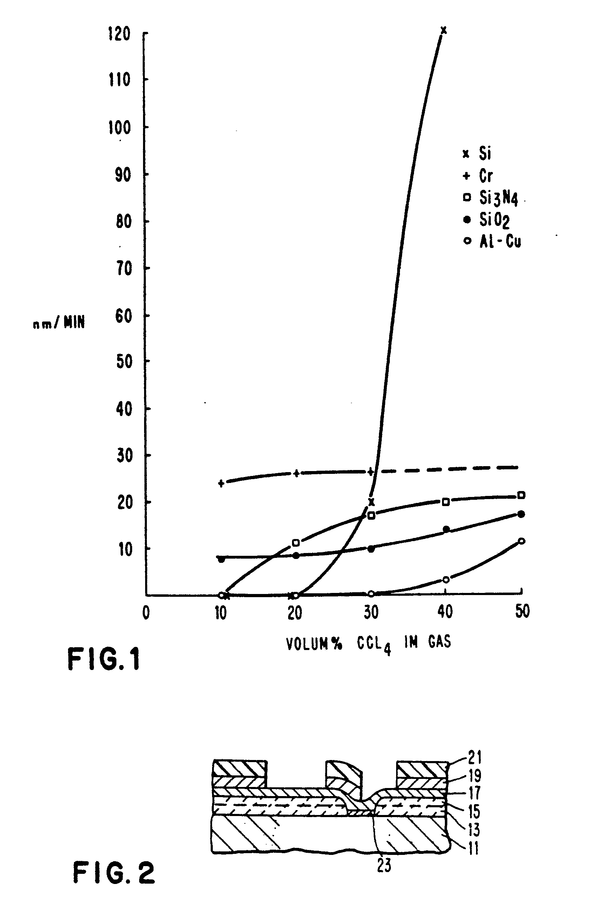

Geeignete Vorrichtungen zum reaktiven Ionenätzen sind bekannt und eine Vorrichtung dieser Art ist beispielsweise in Fig. 1 der US-Patentschrift 3 994 793 abgebildet. In der Vorrichtung zum reaktiven Ionenätzen wird das Substrat, welches geätzt werden soll, auf einer Platte auf einer Kathode angeordnet, welche an eine Hochfrequenzenergiequelle angeschlossen ist. Die Platte kann aus verschiedenen Materialien, beispielsweise aus Quarz, Silicium oder Aluminium, bestehen. Das reaktive Ionenätzverfahren wird durchgeführt bei Drucken von etwa 5 bis 50 Millitorr und in dem erfindungsgemäßen Verfahren vorzugsweise bei Drucken von etwa 10 bis 30 Millitorr. Der Bereich der Energiedichte reicht von etwa 0,1 bis 0,5 Watt/cm³, wobei bei Verwendung organischer Maskenschichten eine Energiedichte von etwa 0,25 Watt/cm² bevorzugt wird, damit ein übermäßiger Verlust an Resistschichtdicke vermieden wird. Die Kathodenplatte kann zusätzlich erhitzt werden, um die Temperatur des Substrats anzuheben und dadurch die Ätzgeschwindigkeiten zu erhöhen. Weil der Photoresist dazu neigt, sich bei höheren Temperaturen zu zersetzen, muß ein Kompromiß zwischen Ätzrate und dem Verlust an Resistschichtdicke gemacht werden.

Als Gasmischungen zur Durchführung des erfindungsgemäßen Verfahrens sind flüchtige polychlorierte organische Materialien mit 1 oder 2 Kohlenstoffatomen, beispielsweise $CCl_4$ und $C_2HCl_3$, gemischt mit Sauerstoff geeignet. Est ist bekannt, daß die polychlorierten Verbindungen Silicium und Aluminium sehr schnell angreifen, aber es wurde überraschenderweise gefunden, daß bei Anwendung von nicht mehr als etwa 20% der polychlorierten Verbindung Silicium und Aluminium nur unwesentlich geätzt werden, während die metallischen Trennschichten aus Chrom, Wolfram, Titan, Tantal und deren Legierungen mit einer vernünftigen Geschwindigkeit, beispielsweise mit etwa 25 bis 60 nm/min geätzt werden können. Bei Konzentrationen über etwa 20% nimmt die Ätzrate des Siliciums stark zu (auf über etwa 5 nm/min) und erreicht bei 30% die Ätzrate des Metalls. Die exakte obere Grenze zur Vermeidung eines erheblichen Ätzens des Siliciums scheint von der Ausbildung der Vorrichtung und den Proben abhängig zu sein, liegt aber bei etwa 20 Vol.%. Bei etwa 40% polychlorierter Verbindung wächst die Ätzrate des Siliciums auf über 100 nm/min an, wie aus Fig. 1 ersichtlich ist. Silicium-oxid- und Siliciumnitridschichten werden in dem erfindungsgemäßen Verfahren mit sehr viel niedrigerer Geschwindigkeit als Chrom geätzt. Deshalb werden diese Schichten, welche üblicherweise auf der Siliciumoberfläche als dielektrische Schichten verwendet werden, die die metallischen Leiterzüge von den Siliciumbauelementen und die verschiedenen Metallisierungsebenen voneinander trennen, nur unwesentlich angegriffen. Das Verhältnis der Ätzraten zwischen den dielektrischen Schichten und den metallischen Trennschichten ist in gewissem Maße von der Anwesenheit oder Abwesenheit maskierender Photoresistschichten abhängig. Wenn eine Photoresistmaske verwendet wird, wird ein noch günstigeres Verhältnis der Ätzraten als das in Fig. 2 dargestellte erhalten, weil die Ätzraten der metallischen Trennschicht bei 40 bis 50 nm liegen, während die Ätzrate dielektrischer Schichten bei oder unter etwa 5 nm/min liegt. Die für das reaktive Ionenätzen angewendeten Bedingungen, die zu den Ergebnissen, die in Fig. 1 dargestellt sind, führen, waren ein Gesamtdruck von 10 Millitorr, eine Energiedichte von 0,25 Watt/cm² und eine Substrattemperatur zu Beginn von 160°C.

Als spezielles Ausführungsbeispiel des erfindungsgemäßen Verfahrens wird das Ätzen eines leitenden Metallisierungsmusters auf einem Halbleiterwafer mit verschiedenen aktiven und passiven Komponenten in der Waferoberfläche beschrieben. Im allgemeinen sind die Wafer mit dielektrischen isolierenden Schichten bedeckt, in denen Kontaktöffnungen zu der Siliciumoberfläche angeordnet sind. Bei einer typischen Anordnung ist die Siliciumoberfläche mit einer ersten, etwa 500 nm dicken Siliciumdioxidschicht, welche thermisch aufgewachsen wurde, bedeckt, gefolgt von einer durch pyrolithische Zersetzung gebildeten Siliciumnitridschicht mit einer Schichtdicke von etwa 160 nm. Metallische Deckschichten werden dann über den dielektrischen Schichten und den Kontaktöffnungen ausgebildet. Die metallischen Schichten werden mit einem Photoresistmuster bedeckt, das das Metall dort, wo es unter Ausbildung des Leiterzugmusters entfernt werden soll, freilegt. Eine typische Struktur für einen metallischen Leiter besteht beispielsweise aus einer relativ dicken Schicht aus Aluminium oder einer Aluminium-Kupferlegierung, die über einer Chrom oder Titan-Wolframschicht, welche als Trennschicht fungiert, gebildet wird, und die auch als Adhäsionsschicht wirkt, so daß die Aluminium-Kupfermetallisierung an der Oberfläche haftet und eine Wechselwirkung zwischen der Aluminumleiterschicht und der Siliciumoberfläche unterbunden wird. Das Aluminium kann nach dem Verfahren gemäß der US-Patentschrift 3 994 793 unter Anwendung einer chlorhaltigen Umgebung in der reaktiven Ionenätzvorrichtung geätzt werden. Die darunterliegende metallische Trennschicht muß entfernt werden können, ohne daß ein übermäßiges Unterschneiden der Aluminiumschicht oder ein Angriff auf das darunterliegende Siliciumsubstrat stattfindet. In den Fällen, in denen Platinsilicid in den Kontaktöffnungen abgeschieden wurde, schützt dieses Material normalerweise die Siliciumoberfläche vor dem Ätzgas, sogar wenn die Resistmaske versetzt angeordnet ist, so daß der Leiterzug die Kontaktöffnung nicht vollständig bedeckt, wie aus Fig. 2 ersichtlich ist. Es können jedoch auch Spalte in dem Platinsilicid auftreten, so daß das Siliciumsubstrat an diesen Stellen dem Plasma ausgesetzt ist und angegriffen würde, wenn es der Gasmischung, die zum Ätzen der Metallschicht verwendet wird, ausgesetzt wäre. Das erfindungsgemäße Verfahren gestattet durch die Anwendung bestimmter Gasmischungen das Ätzen der Metallschicht, ohne daß die Aluminiummetallisierung oder die Siliciumoberfläche in beträchtlichem Maße angegriffen werden.

Das erfindungsgemäße Verfahren eignet sich auch zum aufeinanderfolgenden Ätzen von Metallschichten in einer Vorrichtung zum reaktiven Ionenätzen. Aluminium kann beispielsweise in $CCl_4$ und Argon geätzt werden, bis die metallische Schicht, beispielsweise Chrom, erreicht wird, was durch eine Änderung des Reflexionsvermogens mittels eines Reflektometers angezeigt wird. Die Gasatmosphäre wird dann zum Ätzen von Chrom gewechselt zu einer Mischung von beispielsweise etwa 20 Vol.% CCl$_4$ und 80 Vol.% Sauerstoff, indem der Zufluß von Argon unterbrochen und Sauerstoff zugeführt wird, und schließlich wird das Gas gewechselt, indem Sauerstoff oder ein anderes Gas, das zum Abtragen des Resists geeignet ist, zugeführt wird. Bei dieser Folge werden die Probleme der Korrosion, die durch eine hohe Absorption von Chlor an Chrom während des Aluminiumätzens hervorgerufen werden, auf ein Minimum herabgesetzt. Die Absorption von Chlor an Chrom kann eine schnelle Reaktion des Chlors mit dem Aluminium bewirken, was immer dann auftritt, wenn der Wafer zur Vollendung des Chromätzens in eine andere Apparatur überführt wird.

### Beispiel 1

Die Ätzraten, die in Fig. 1 angegeben sind, wurden erhalten, indem Siliciumwafer oder Teile von Siliciumwafern, die mit dem Material, an dem die Ätzrate bestimmt werden sollte, bedeckt waren, in eine Kammer für das reaktive Ionenätzen eingebracht wurden, wobei die Substrate auf 160°C vorgeheizt wurden. Der Gesamtdruck betrug 10 Millitorr, die Energiedichte war 0,25 Watt/cm$^2$ und die Gaszusammensetzungen enthielten 10 bis 50 Vol.% CCl$_4$ mit dem Rest Sauerstoff. Die Proben wurden maskiert, indem man ein ungefähr 1,27 x 1,27 cm Siliciumchip mit einer Dicke von etwa 0,38 mm auf das Substrat legte, um diesen Bereich vor dem Plasma des reaktiven Ionenätzens zu schützen. Die Stufe, die durch den Ätzprozeß hergestellt wurde, wurde durch ein Taly Step gemessen. Die Ätzzeiten betrugen etwa 2 bis 5 Minuten und die mittleren Ätzraten wurden bestimmt, indem die Ätzzeit durch die mit dem Taly Step gemessenen Stufen, welche durch Ätzen der Materialoberfläche in denjenigen Bereichen erzeugt wurden, die nicht durch das Siliciumchip bedeckt waren, dividiert wurde. Es ist ersichtlich, daß bei Konzentrationen von CCl$_4$ von 20 Vol.% oder darunter kein meßbares Ätzen des Siliciums beobachtet wurde, und unter 30 Vol.% wurde auch kein Ätzen des Aluminium-Kupfers beobachtet. Die Ätzrate für Chrom andererseits war bei Anwendung einer Mischung mit einem Gehalt zwischen 10 und 30 Vol.% CCl$_4$ annähernd konstant und lag bei etwa 25 nm/min. Es ist ersichtlich, daß Konzentrationen von CCl$_4$ bis unter 10 Vol.% zum Ätzen von Chrom geeignet sind.

### Beispiel 2

Eine Probe eines Siliciumwafers mit Schichten von thermischem Oxid und pyrolithisch aufgewachsenem Siliciumnitrid, einer 50 nm dicken Tantalschicht auf dem Nitrid, einer 100 nm dicken Schicht von TiW (10% Ti) auf der Tantalschicht und einer 1 um dicken Schicht Aluminiumkupfer auf der Titan-Wolframschicht wurde mit einer 1 um dicken Schicht eines positiven Photoresists (Shipley AZ1350, einem m-Kresol-Formaldehyd-Novolakharz mit einem Diazoketonsensibilisator) beschichtet. In dem Resist wurde ein Muster erzeugt, um Teile der Aluminium-Kupferschicht freizulegen, und die Aluminium-Kupferschicht wurde bis zu der Titan-Wolframoberfläche in einer Vorrichtung für reaktives Ionenätzen in einer Atmosphäre von CCl$_4$ und Sauerstoff, wie in der US-Patentschrift 3 994 793 beschrieben, geätzt. Die Titan-Wolframund Tantalschichten wurden dann bis zur Siliciumnitridoberfläche hin entfernt durch Ätzen mit einer Gasmischung von 20 Vol.% CCl$_4$ und 80 Vol.% Sauerstoff bei einem Gesamtdruck von 10 Millitorr. Die Reaktorbedingungen waren die gleichen wie in Beispiel 1 angegeben, die Energiedichte betrug etwa 0,25 Watt/cm$^2$ und das Substrat wurde auf eine Temperatur von 160°C vorerhitzt.

### Beispiel 3

Um die Ätzgeschwindigkeit in verschiedenen Gasmischungen zu bestimmen, wurden Siliciumwafer mit den Schichten auf der Oberfläche, die in Tabelle 1 angeführt sind, mit verschiedenen Gasmischungen geätzt. Die Proben wurden in jedem Fall teilweise mit etwa 1 bis 2 um dicken Photoresistschichten maskiert. Nach dem Ätzen wurde der Resist in einem Sauerstoffplasma entfernt und der Ätzschritt wurde zur Bestimmung der Ätzraten mit einem Taly Step gemessen. Die Energiedichte betrug 0,25 Watt/cm$^2$, und die Proben wurden auf etwa 160°C vorerhitzt. Das Substrat bestand aus einem polierten P$^-$-Silicium, das Siliciumdioxid war eine etwa 500 nm dicke Schicht eines thermisch aufgewachsenen Oxids, und das Siliciumnitrid bestand aus einer 160 nm dicken Schicht eines pyrolithisch niedergeschlagenen Materials. Die Metallfilme waren etwa 100 nm dicke Filme, die im Falle des Titan-Wolframs durch Gleichstrom-Kathodenzerstäubung auf das mit Siliciumdioxid bedeckte Silicium niedergeschlagen wurden, und im Falle des Chroms wurde das mit Oxid beschichtete Silicium aus einer Chromquelle durch Elektronenstrahlsublimation bedeckt.

TABELLE 1

| Ätzmittel | Partialdrucke in Millitorr | | | Ätzrate (nm /Min) | | | |
| --- | --- | --- | --- | --- | --- | --- | --- |
| $C_2HCl_3$ | $CCl_4$ | $O_2$ | Cr | TiW * | Si | $SiO_2$ | $Si_3N_4$ |
| 10 | — | 10 | 22,5 | — | 100 | 12,5 | 19 |
| 5 | — | 15 | 40 | — | 10 | 1 | 1,5 |
| 2 | — | 8 | 40 | — | 5 | 5 | 5 |
| 5 | — | 5 | 18 | — | 58 | 20 | 15 |
| 10 | — | 10 | — | 37,5 | 44,7 | 13,3 | — |
| — | 5 | 15 | 40 | — | 10 | 5 | 5 |
| — | 2 | 18 | 29,3 | — | 2 | 2 | 2 |
| — | 2 | 8 | 42,5 | — | 2,5 | 2,5 | 2,5 |
| — | 2 | 8 | 26 | 22 | 2,5 | 2,5 | — |
| — | 5 | 5 | 49 | — | 115 | 12,5 | 22 |
| — | 5 | 5 | 26 | 190 | — | 2,5 | — |
| — | 3 | 7 | 23,3 | 130 | — | 2,5 | — |

\* 10 und 30 % Ti

Wie aus den Ergebnissen in Tabelle 1 er-. sichtlich ist, ergaben Konzentrationen des chlorhaltigen Gases von 20 Vol.% und darunter Chromätzraten von etwa 25 bis 40 nm/min und Ätzraten für Silicium von etwa 5 bis unter 2 nm/min.

Die Ätzratenverhältnisse von Chrom zu Oxid und Nitrid in diesen Gaszusammensetzungen waren auch sehr günstig. Es ist ersichtlich, daß Konzentrationen von 25 und 50% des chlorhaltigen Gases das Ätzen des Siliciums in erheblichem Maße bewirken. Die Raten liegen bei etwa 10 nm/Min bei 25% und nehmen schnell auf etwa 100 nm/Min zu, wenn die Konzentrationen auf 50 Vol.% anstiegen.

Die Titan-Wolfram-Ätzrate scheint auch bei niedrigeren Konzentrationen von $CCl_4$ abzufallen, wobei einige Daten Ätzraten von über 100 nm/Min bei Konzentrationen von 30 und 50 Vol.% $CCl_4$ ergeben. Zum vollständigen Ätzen von Titan-Wolfram ohne gleichzeitigem Anätzen von Silicium werden Konzentrationen von etwa 20 Vol.% bevorzugt.

### Beispiel 4

In Fig. 2 ist die Struktur einer typischen Leiterzugmetallisierung angegeben, die mit dem erfindungsgemäßen Verfahren geätzt werden kann. Auf dem Siliciumsubstrat ist eine 200 nm dicke Schicht 13 eine thermischen Oxids, ein 160 nm dicke Schicht 15 eines pyrolytisch abgeschiedenen Siliciumnitrids, eine 100 nm dicke Chromschicht 17 und eine 1000 nm dicke Aluminium-Kupferschicht 19 angeordnet. Eine Resistmaske 21 wird aufder Aluminiumschicht 19 gebildet. In dieser wird ein Muster erzeugt, um die Bereiche der Schicht 19, welche durch Ätzung entfernt werden sollen, zu definieren. Eine Schicht 23 aus Platinsilicid wird in den Kontaktöffnungen 25 hergestellt. Wie gezeigt, wird die Aluminium-schicht bis zur Chromschicht in den freigelegten Bereichen abgeätzt. Die Resistmaske überlappt nur teilweise den Bereich der Kontaktöffnung, so daß ein Teil des Chroms über dem Platinsilicid freigelegt ist. Das Substrat wird auf einer Quarzplatte an der Kathode angeordnet und auf 160°C erhitzt. Die Aluminium-Kupferschicht wird mit einer Mischung von $CCl_4$ (2 Millitorr) und Argon (8 Millitorr) in etwa 9 Minuten abgeätzt, und dann wird, ohne das Plasma abzustellen, das Argon gegen Sauerstoff (8 Millitorr) in der ätzenden Atmosphäre ausgetauscht, und das Chrom wird in etwa 2 Minuten und 45 Sekunden abgeätzt. Es wurde beobachtet, daß ein Ring nicht abgeätzten Chroms um das Aluminium-Kupfermuster herum zurückblieb, wenn die Glimmentladung während des Austausches abgeschaltet wurde. Der Resist wurde in Sauerstoff bei einem Druck von 20 Millitorr in etwa 20 Minuten entfernt. Die Hochfrequenzenergie betrug durchweg 180 Watt (0,25 Watt/cm²).

Das erfindungsgemäße Verfahren gestattet bei der Ausbildung der Leiterzüge integrierter Schaltkreise das Ätzen von Metallen wie Chrom, Wolfram, Titan und Tantal, ohne daß Aluminium-Kupfer, Silicium und dielektrische Schichten wie Siliciumdioxid und Siliciumnitrid in stärkerem Maße angegriffen werden.

**Patentansprüche**

1. Verfahren zum Entfernen einer Metallschicht von einem Halbleiterkörper durch reaktives Ionenätzen, dadurch gekennzeichnet, daß die Metallschicht (17) aus Chrom, Titan, Wolfram, Tantal oder aus Legierungen derselben auf dem Halbleiterkörper (11, 13, 15) einer Glimmentladung in einer Atmosphäre mit einem Gehalt an polychlorierter organischer Verbindung mit 1 oder 2 C-Atomen von 5 bis 20 Vol.% und an Sauerstoff von 80 bis 95 Vol.% bei einem Gesamtdruck von 5 bis 50 Millitorr ausgesetzt wird.

2. Verfahren nach Anspruch 1, dadurch gekennzeichnet, daß als polychlorierte Verbindung $CCl_4$ oder $C_2HCl_3$ angewendet wird.

3. Verfahren nach den Ansprüchen 1 und 2, dadurch gekennzeichnet, daß eine Glimmentladung mit einer Energiedichte von 0,1 bis 0,5 Watt/cm² in einer Gasmischung von 10 bis 20 Vol.% $CCl_4$ oder $C_2HCl_3$ und 80 bis 90 Vol.% Sauerstoff bei einem Gesamtdruck von 10 bis 20 Millitorr erzeugt wird.

4. Verfahren nach Anspruch 1, dadurch gekennzeichnet, daß eine Maske (21) über der Metallschicht (17) hergestellt wird, die die zu entfernenden Bereiche derselben definiert.

5. Verfahren nach Anspruch 1, dadurch gekennzeichnet, daß der Halbleiterkörper (11) aus Silicium, auf dem eine oder mehrere dielektrische Schichten (13, 15) mit Durchführungsöffnungen zur Siliciumoberfläche angeordnet sind, besteht.

6. Verfahren nach den Ansprüchen 1 bis 3, dadurch gekennzeichnet, daß die Metallschicht (17) aus einer Titan-Wolfram-Legierung mit einer Gasmischung aus etwa 20 Vol.% polychlorierter organischer Verbindung und etwa 80 Vol.% Sauerstoff entfernt wird.

7. Verfahren nach den Ansprüchen 1 und 4, dadurch gekennzeichnet, daß zwischen der Maske (21) und der Metallschicht (17) eine aluminiumhaltige Schicht (19) angeordnet ist, die durch reaktives Ionenätzen in einer Atmosphäre von $CCl_4$ und Argon entfernt wird, und daß anschließend ohne Unterbrechen der Glimmentladung die Metallschicht (17) in einem Gasgemisch, in dem Argon durch Sauerstoff ersetzt wurde, entfernt wird.

8. Verfahren nach den Ansprüchen 1 und 7, dadurch gekennzeichnet, daß als Maske (21) eine Photoresistmaske angewendet wird, die nach dem Ätzen der Metallschichten (17, 19) in einem Sauerstoffplasma entfernt wird.

**Revendications**

1. Procédé pour enlever une couche métallique d'un corps semi-conducteur en utilisant le décapage par ions réactifs, caractérisé en ce que la couche métallique (17) à base de chrome, titane, tungstène, tantale, ou de combinaisons de ces derniers est soumise sur le corps semi-conducteur (11, 13, 15) à une décharge lumineuse dans une atmosphère comportant, d'une part, de 5 à 20% en volume d'un composé organique polychloré contenant 1 ou 2 atomes de carbone et, d'autre part, de 80 à 95% en volume d'oxygène à une pression totale de 5 à 50 millitorrs.

2. Procédé selon la revendication 1, caractérisé en ce que le composé polychloré est du $CCl_4$ ou $C_2HCl_3$.

3. Procédé selon les revendications 1 et 2, caractérisé en ce que l'on produit une charge lumineuse d'une densité d'énergie de 0,1 à 0,5 watts/cm² dans un mélange gazeux de 10 à 20% en volume de $CCl_4$ ou $C_2HCl_3$ et de 80 à 90% en volume d'oxygène à une pression totale de 10 à 20 millitorrs.

4. Procédé selon la revendication 1, caractérisé en ce que l'on produit sur la couche de métal (17) un masque (21) aui définit les régions à enlever de ladite couche.

5. Procédé selon la revendication 1, caractérisé en ce que le corps semi-conducteur (11) est composé de silicium sur lequel on dépose une ou plusieurs couches diélectriques (13, 15) pourvue(s) d'ouvertures de traversée jusqu'à la surface de silicium.

6. Procédé selon les revendications 1 à 3, caractérisé en ce que l'on enlève la couche métallique (17) composée d'un alliage de titane-tungstène à l'aide d'un mélange gazeux à environ 20% en volume du composé organique polychloré et à environ 80% en volume d'oxygène.

7. Procédé selon les revendications 1 et 4, caractérisé en ce qu'entre le masque (21) et la couche métallique (17) se trouve une couche contenant de l'aluminium (19) qui est enlevé part décapage par ions réactifs dans une atmosphère de $CCl_4$ et d'argon et en ce que, ultérieurement et sans interrompre la décharge lumineuse, on décape la couche métallique (17), dans un mélange gazeux dans lequel l'argon a été remplacé par l'oxygène.

8. Procédé selon les revendications 1 et 7, caractérisé en ce que l'on utilise comme masque (21) un masque de résine photosensible que l'on enlève dans un plasma d'oxygène après décapage des couches métalliques (17, 19).

**Claims**

1. Process for removing a metal layer from a semiconductor body through reactive ion etching, characterized in that the metal layer (17) of chromium, titanium, tungsten, tantalum, or of alloys thereof is subjected on the semiconductor body (11, 13, 15) to a glow discharge in an atmosphere comprising a polychorinated organic compound containing 1 or 2 C-atoms of 5 to 20 percent by volume, and also comprising oxygen of 80 to 95 percent by volume with an overall pressure of 5 to 50 millitorr.

2. Method as claimed in claim 1, characterized in that $CCl_4$ or $C_2HCl_3$ is used as a polychlorinated compound.

3. Method as claimed in claims 1 and 2, characterized in that a glow discharge with an energy density of 0.1 to 0.5 watt/cm² in a gaseous mixture of 10 to 20 percent by volume $CCl_4$ or $C_2HCl_3$, and 80 to 90 percent by volume oxygen with a total pressure of 10 to 20 millitorr is generated.

4. Method as claimed in claim 1, characterized in that a mask (21) is made over the metal layer (17) which defines the metal layer portions to be removed.

5. Method as claimed in claim 1, characterized in that the semiconductor body (11) consists of silicon having one or several dielectric layers (13, 15) with openings to the silicon surface arranged thereon.

6. Method as claimed in claims 1 to 3, characterized in that the metal layer (17) of a titanium-tungsten alloy is removed with a gaseous mixture of approximately 20 percent by volume polychlorinated organic compound and approximately 80 percent by volume oxygen.

7. Method as claimed in claims 1 to 4, characterized in that between the mask (21) and the metal layer (17) an aluminium-containing layer (19) is arranged which is removed by reactive ion etching in an atmosphere of $CCl_4$ and argon, and that subsequently without interruption of the glow discharge the metal layer (17) is etched in a gaseous mixture where argon has been replaced by oxygen.

8. Method as claimed in claims 1 to 7, characterized in that as a mask (21) a photoresist mask is used which after the etching of the metal layers (17, 19) is stripped in an oxygen plasma.

FIG.1

nm/MIN

VOLUM% CCL₄ IM GAS

× Si
+ Cr
□ Si₃N₄
● SiO₂
○ Al-Cu

FIG.2